# EUROPEAN PATENT APPLICATION

(11) **EP 4 369 427 A1**
(43) Date of publication of application: **15.05.2024**
(21) Application number: 22207360.3
(22) Date of filing: 14.11.2022
(51) Int. Cl.: H01L 33/14, H01L 33/36, H01L 33/32

(54) **P-TYPE TUNNELING-BASED OHMIC CONTACT AND METHOD OF ITS FABRICATION**

(71) Applicant: RISE Research Institutes of Sweden AB, 501 15 Borås (SE)
(72) Inventor: Ramvall, Peter, 22474 Lund (SE); Kumar, Ashutosh, 22468 Lund (SE); Berg, Martin, 22735 Lund (SE); Wang, Qin, 19137 Sollentuna (SE); Salter, Michael, 16570 Hässelby (SE)
(74) Representative: AWA Sweden AB

(57) **Abstract**

A far-UVC device (100) for emitting and detecting far-UVC light comprising: a substrate (102); at least one conductive layer (106) arranged on the substrate (102); a first electrical contact (108) arranged on the at least one conductive layer (106); a far-UVC quantum well (120) comprising an aluminum-gallium-nitride based stack, wherein the far-UVC quantum well (120) is arranged on the conductive layer (106); an aluminum-gallium-nitride based electron blocking layer (EBL) (126) arranged on the quantum well (120); a p-type AlₐGa₁₋ₐN layer (132) arranged on the EBL (126) and being in electrical contact with the quantum well (120), wherein the device (100) further comprises an n-type (Al_{b}Ga_{1-b})₂O₃ layer (134) interposed between a second electrical contact (136) and the p-type AlₐGa₁₋ₐN layer (132), wherein b is from and including 0 to and including 1 and a is from and including 0 to and including 1.

## Description

### Technical field

The present description relates to the field of far ultra-violet (far-UVC) devices for emitting and detecting far-UVC light comprising tunneling-based ohmic contacts, and methods of fabrication thereof.

### Background

Ultraviolet (UV) light is effective against microbes, including some viruses. Unfortunately, UV light is also harmful to human and animal cells. However, that only applies to UV-A and UV-B rays from the sun; the so-called far-UVC light (with a wavelength in a range of approximately 200-230 nm) cannot penetrate human skin and, thus, may be considered safe. The far most common solution producing safe far-UVC is excimer lamps. These lamps are relatively bulky, and not suitable for everyday use.

An alternative to excimer lamps is LEDs. However, even though semiconductor-based UV emitters generally have many advantages over conventional UV sources, there are still challenges when it comes to achieving light of shorter wavelengths, such as far-UVC.

LEDs and laser diodes configured to emit far-UVC light may use nitride-based materials, such as using nitrides comprising aluminum, gallium and/or indium. Aluminum nitride, AIN, exhibits the largest bandgap and is therefore useful for emission of far-UVC light.

Amongst the challenges for achieving far-UVC light using a LED, one of the most prominent challenges is to obtain low-resistivity ohmic contacts on the p-side of the LED. The main reason is that the ionization energy of Mg, the only suitable p-dopant for nitride semiconductors, increases with increasing Al content. Further, there are no metals with high enough work function to create an ideal p-type ohmic contact to the AlₓGa₁₋ₓN which may need to be used in the LED for emitting far-UVC light. The resulting high resistance of the p-type ohmic contact will lead to an excessive voltage drop and heat dissipation that will cause two problems: Firstly, the heat dissipation puts strong requirements on the cooling (packaging) of the device and leads to a lowering of the wall-plug efficiency of the LED. Secondly, to compensate for the voltage drop over the p-contact, more powerful drive electronics is required which, for a hand-held device, means more battery capacity is required making the device bulkier and less attractive for everyday use.

Therefore, there is a need for an improved solution.

### Summary

An objective of the present description is to provide an improved semiconductor-based device capable of emitting and detecting far-UVC light, which has low voltage drop and thus, low heat dissipation. It is also an objective to provide a method of fabricating such a device.

These and other objectives are at least partly met by the invention as defined in the independent claims. Preferred embodiments are set out in the dependent claims.

According to a first aspect, there is provided a far-UVC device for emitting and/or detecting far-UVC light, the device comprising: a substrate; at least one conductive layer arranged on the substrate; a first electrical contact arranged on the at least one conductive layer; a far-UVC quantum well comprising an aluminum-gallium-nitride based stack, wherein the far-UVC quantum well is arranged on the conductive layer; an aluminum-gallium-nitride based electron blocking layer (EBL) arranged on the quantum well; a p-type AlₐGa₁₋ₐN layer arranged on the EBL and being in electrical contact with the quantum well, wherein the device further comprises an n-type (Al_{b}Ga_{1-b})₂O₃ layer interposed between a second electrical contact and the p-type AlₐGa₁₋ₐN layer, wherein b is from and including 0 to and including 1 and a is from and including 0 to and including 1.

By b being from and including 0 to and including 1 it is entailed that b may have any value within the interval 0 to 1, including the end points. As such, b may for example be 0, or 0.1, or 0.2, or 0.3, or 0.4, or 0.5, or 0.6, or 0.7, or 0.8, or 0.9, or 1. The same is true for a. Thus, a may for example be 0, or 0.1, or 0.2, or 0.3, or 0.4, or 0.5, or 0.6, or 0.7, or 0.8, or 0.9, or 1.

Thanks to the far-UVC device of the first aspect, the second electrical contact forms an n-type ohmic contact to the n-type (Al_{b}Ga_{1-b})₂O₃ layer, and, together with the p-type AlₐGa₁₋ₐN layer, a p-type tunnelling-based ohmic contact. Hence, an ohmic contact displaying low electrical resistance is formed. This allows the far-UVC device to operate without generating an excessive amount of heat. Thus, the requirements on the cooling (packaging) of the device may be low. Further, it is facilitated to maintain a high wall-plug efficiency of the LED.

Since the ohmic contact displays a low electrical resistance, more powerful drive electronics are not required in order to compensate for a high voltage drop over the p-contact. Therefore, the device need not have a higher battery capacity which would make the device bulky and less attractive for everyday use. In particular, the device may be constructed so as to being hand-held.

Thanks to the ohmic contact comprising an (Al_{b}Ga_{1-b})₂O₃ layer, a stable device is provided, since (Al_{b}Ga_{1-b})₂O₃ layers are stable in air, even at high temperatures.

Further, during manufacturing, the (Al_{b}Ga_{1-b})₂O₃ layer may be formed in a separate process than what is used for forming the p-type AlₐGa₁₋ₐN layer. Suitable deposition methods for forming the (Al_{b}Ga_{1-b})₂O₃ layer may be physical vapor deposition such as magnetron sputtering, pulsed laser deposition, or e-beam evaporation. This allows for the possibility to deposit the second electrical contact using the same tool for forming (Al_{b}Ga_{1-b})₂O₃ layer. This improves control of an interface between the second electrical contact and the (Al_{b}Ga_{1-b})₂O₃ layer or any other intermediate layer being interposed between the second electrical contact and the (Al_{b}Ga_{1-b})₂O₃ layer. Thus, the amount of interface traps may be reduced.

The substrate may be formed of a transparent material. The substrate may be configured to allow light to be transmitted. The substrate may be formed of a material being transparent to far-UVC. The substrate may be formed of sapphire. Sapphire is inexpensive, readily available and is transparent to far-UVC.

The at least one conductive layer arranged on the substrate may further be any type of conductive layer. For example, the conductive layer may be an n-type AlₑGa₁₋ₑN layer, wherein e is from and including 0 to and including 1.

The quantum well comprising an aluminum-gallium-nitride based stack implies that the quantum well comprises a plurality of layers arranged on top of each other for forming a stack of layers. The stack being aluminum-gallium-nitride based implies that layers of the stack comprise aluminum-gallium-nitride. The quantum well may comprise any number of layers. Furthermore, the layers of the quantum well may differ from each other. For example, the quantum well may comprise alternating layers having different compositions. The quantum well may, e.g., comprise alternating layers of Al_{0.9}Ga_{0.1}N and Al_{0.8}Ga_{0.2}N. For example, the quantum well may comprise five layers of Al_{0.9}Ga_{0.1}N and five layers of Al_{0.8}Ga_{0.2}N.

The EBL may be configured to block electrons from entering the p-type AlₐGa₁₋ₐN layer. This implies that the EBL facilitates in preventing that recombination, and thus charge neutralization, occurs in the p-type AlₐGa₁₋ₐN layer. Hence, parasitic effects may be reduced.

As used herein, the term *"far-UVC"* should be interpreted as electromagnetic radiation corresponding to a wavelength range of approximately 200-230 nm.

It should be realized that the far-UVC device may be used for emitting far-UVC light based on signals provided to the first electrical contact and the second electrical contact. However, the far-UVC device may alternatively be used for detecting far-UVC light, wherein far-UVC light incident on the far-UVC quantum well may be converted to signals to the first electrical contact and the second electrical contact which may be read out for detecting the far-UVC light.

The far-UVC device may be configured to emit light in a direction perpendicular to layers of the stack of the quantum well. The far-UVC device may thus be configured to emit light through the substrate and/or the second electrical contact. According to another embodiment, the far-UVC device may be configured to emit light through sides of the stack of the quantum well, the sides extending perpendicular to the layers of the stack. The far-UVC device may comprise reflective structures for controlling a direction of light being output from the far-UVC device.

The far-UVC device being configured to detect light may be configured to control a direction of incident light. Thus, the far-UVC device may comprise reflective and/or absorbing structures preventing light from entering the quantum well unless the light is incident from a desired direction.

According to an embodiment, the p-type AlₐGa₁₋ₐN layer is compositionally graded such that, at an interface with the EBL, a is different than at an interface with the n-type (Al_{b}Ga_{1-b})₂O₃ layer.

By this configuration of the p-type AlₐGa₁₋ₐN layer, the composition, and thereby the lattice constant, of the p-type AlₐGa₁₋ₐN layer at the two interfaces may be tailored in order to reduce crystal defects and charge carrier traps. This facilitates providing of a stable and efficient device.

The composition of the p-type AlₐGa₁₋ₐN layer may be graded in a variety of ways. For example, the aluminum content of the composition may increase or decrease between the interface with the EBL and the interface with the (Al_{b}Ga_{1-b})₂O₃ layer.

Further, this configuration of the p-type AlₐGa₁₋ₐN layer entails a possibility of utilizing polarization doping which may provide an increased number of carriers and thus improved conductivity of the p-type AlₐGa₁₋ₐN. The increased number of carriers may also provide an enhanced light emission of an active region of the quantum well hence allowing for a high output emission of the device.

According to an embodiment, a is 0.9 at the interface with the EBL and a is 0 at the interface with the (Al_{b}Ga_{1-b})₂O₃ layer.

That is, the composition of the p-type AlₐGa₁₋ₐN layer may be configured such that the p-type AlₐGa₁₋ₐN layer may be a p-type Al_{0.9}Ga_{0.1}N layer at the interface with the EBL and a p-type GaN layer at the interface with the (Al_{b}Ga_{1-b})₂O₃ layer. This composition of the p-type AlₐGa₁₋ₐN layer may be suitable for the uses associated with the far-UVC device discussed herein.

According to an embodiment, the second electrical contact is a metal.

According to an embodiment, the second electrical contact is an n-type semiconductor material.

The first electrical contact and the second electrical contact may be made of any suitable material. The first electrical contact may be, but is not limited to being, made of the same material as the second electrical contact. As such, the first and the second electrical contact may be a metal material. Alternatively, the first and the second electrical contact may be an n-type semiconductor material. Furthermore, the first electrical contact and the second electrical contact may be transparent. For example, the first electrical contact and/or the second electrical contact may be transparent for wavelengths in the range of 4.0 to 8.0 eV, or 4.25 to 7.5 eV, or 4.5 to 7.0 eV. This is advantageous since the amount of light absorption in the first electrical contact and the second electrical contact may be reduced.

According to an embodiment, the n-type (Al_{b}Ga_{1-b})₂O₃ layer has a bandgap in the range of 4.0 to 8.0 eV, or 4.25 to 7.5 eV, or 4.5 to 7.0 eV.

The composition of the n-type (Al_{b}Ga_{1-b})₂O₃ layer may be such so as to form an n-type (Al_{b}Ga_{1-b})₂O₃ layer having a bandgap of 4.0 to 8.0 eV, or 4.25 to 7.5 eV, or 4.5 to 7.0 eV. This is advantageous since the amount of light absorption in the n-type (Al_{b}Ga_{1-b})₂O₃ may be reduced.

According to an embodiment, the device further comprises an Al_{c}Ga_{1-c}N strain relaxation layer interposed between the substrate and the at least one conductive layer, wherein c is from and including 0 to and including 1.

The strain relaxation layer may mitigate any differences in lattice constant between the substrate and the conductive layer, such that the amount of crystal defects may be reduced.

According to an embodiment, the device further comprises a modification layer interposed between the p-type AlₐGa₁₋ₐN layer and the n-type (Al_{b}Ga_{1-b})₂O₃ layer.

The modification layer may e.g., facilitate the formation of the n-type (Al_{b}Ga_{1-b})₂O₃ layer. The modification layer may also mitigate any differences in lattice constant between the p-type AlₐGa₁₋ₐN layer and the n-type (Al_{b}Ga_{1-b})₂O₃ layer. The modification layer may further reduce interface traps.

According to a second aspect, a method for fabricating a far-UVC device for emitting and/or detecting far-UVC light is provided, the method comprising: depositing at least one conductive layer on a substrate; forming a quantum well for light emittance or detection comprising alternatingly depositing layers of aluminum-gallium-nitride on the at least one conductive layer so as to form an aluminum-gallium-nitride based stack; forming an aluminum-gallium-nitride based electron blocking layer (EBL) on the quantum well; depositing a p-type AlₐGa₁₋ₐN layer on the EBL, wherein a is from and including 0 to and including 1; forming an n-type (Al_{b}Ga_{1-b})₂O₃ layer on the p-type AlₐGa₁₋ₐN layer, wherein b is from and including 0 to and including 1; covering the stack of layers with a first mask; partially etching the first mask so as to expose a portion of the at least one conductive layer; depositing a first electrical contact on the at least one conductive layer; covering the first mask, the first electrical contact, and the (Al_{b}Ga_{1-b})₂O₃ layer with a second mask; partially etching the second mask and the first mask, and depositing a second electrical contact on the n-type (Al_{b}Ga_{1-b})₂O₃ layer;

Effects and features of this second aspect are largely analogous to those described above in connection with the first aspect. Embodiments mentioned in relation to the second aspect are largely compatible with the first aspect.

By the method a far-UVC device for emitting and/or detecting far-UVC light according to the first aspect is fabricated. The different layers of the far-UVC device for emitting and detecting far-UVC light may be deposited or formed by any known fabrication technique, such as epitaxy, chemical vapor deposition (CVD) or physical vapor deposition (PVD). As such, the method according to the second aspect is employable in a fabrication apparatus, or in a combination of fabrication apparatuses, readily available in the technical field.

According to an embodiment, depositing a p-type AlₐGa₁₋ₐN layer comprises gradingly depositing aluminum such that the p-type AlₐGa₁₋ₐN layer is compositionally graded such that, at an interface with the EBL, a is different than at an interface with the n-type (Al_{b}Ga_{1-b})₂O₃ layer.

Gradingly depositing aluminum is to be understood as varying the amount of aluminum deposited over time during the deposition. Hereby, the composition, and thereby the lattice constant, of the p-type AlₐGa₁₋ₐN layer at the two interfaces may be tailored in order to reduce crystal defects and charge carrier traps. Thus, a stable and efficient device is fabricated.

The p-type AlₐGa₁₋ₐN layer may further be treated such that the formation of the n-type (Al_{b}Ga_{1-b})₂O₃ layer is facilitated, and/or such that surface deformities and impurities are reduced.

According to an embodiment, the method further comprises depositing a modification layer on the p-type AlₐGa₁₋ₐN layer, such that the modification layer is interposed between the p-type AlₐGa₁₋ₐN layer and the n-type (Al_{b}Ga_{1-b})₂O₃ layer.

The modification layer may e.g., facilitate the formation of the n-type (Al_{b}Ga_{1-b})₂O₃ layer. The modification layer may also mitigate any differences in lattice constant between the p-type AlₐGa₁₋ₐN layer and the n-type (Al_{b}Ga_{1-b})₂O₃ layer. The modification layer may further reduce interface traps.

According to an embodiment, forming an n-type (Al_{b}Ga_{1-b})₂O₃ layer comprises depositing a catalyst layer on the p-type AlₐGa₁₋ₐN layer and growing the n-type (Al_{b}Ga_{1-b})₂O₃ layer in contact with the catalyst layer.

The catalyst layer may comprise any suitable catalyst. For example, the catalyst layer may comprise antimonide. The catalyst layer may, e.g., facilitate the formation of the (Al_{b}Ga_{1-b})₂O₃ layer. It may be noted that the catalyst layer need not be directly on and in direct contact with the p-type AlₐGa₁₋ₐN. On the contrary, the catalyst layer may be deposited on any other layer being arranged on the p-type AlₐGa₁₋ₐN layer.

Generally, all terms used in the claims are to be interpreted according to their ordinary meaning in the technical field, unless explicitly defined otherwise herein. All references to "a/an/the [element, device, component, means, step, etc.]" are to be interpreted openly as referring to at least one instance of said element, device, component, means, step, etc., unless explicitly stated otherwise. The steps of any method disclosed herein do not have to be performed in the exact order disclosed, unless explicitly stated.

### Brief description of the drawings

The above, as well as additional objects, features, and advantages of the present inventive concept, will be better understood through the following illustrative and non-limiting detailed description, with reference to the appended drawing. In the drawings like reference numerals will be used for like elements unless stated otherwise.
Fig. 1 is a schematic view of a cross-section of a far-UVC device according to an embodiment.
Figs. 2a-d illustrate the first and second electrical contact formation steps of a method applied to a preliminary far-UVC device according to an embodiment in a schematically depicted cross-sectional view.

### Detailed description

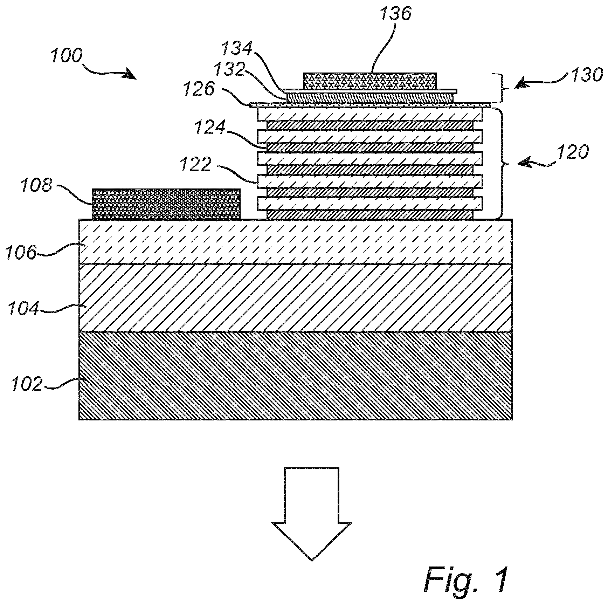

Referring now to Fig. 1, a far-UVC device 100 according to an embodiment will be discussed. The far-UVC device 100 is configured to provide emission and/or detection of far-UVC light.

The far-UVC device 100 comprises a substrate 102. The substrate 102 may be configured to be transparent so as to allow light to be transmitted through the substrate. The substrate 102 may be formed of a material being transparent to far-UVC.

The substrate 102 may be formed of sapphire. Sapphire is inexpensive, readily available and is transparent to far-UVC. Alternatively, the substrate 102 may be formed of aluminum nitride (AIN). AIN has a wide bandgap and is highly transparent to far-UVC which allows for high output emission. Further, AIN is stable at high temperatures. Hence, by the substrate 102 being formed of AIN, it is provided a device which may operate at high temperatures.

At least one conductive layer 106 is arranged on the substrate 102. The at least one conductive layer 106 may be any type of conductive layer. For instance, the at least one conductive layer 106 may be an n-type AlₑGa₁₋ₑN layer.

The composition of the at least one n-type AlₑGa₁₋ₑN layer may vary where e is from and including 0 to and including 1. For example, the at least one conductive layer 106 may be an n-type Al_{0.9}Ga_{0.1}N layer. Each of the at least one conductive layer 106 may differ in composition, thickness and doping concentration.

The at least one conductive layer 106 may be doped. The at least one conductive layer 106 may be in the range of n-doping = 1 × 10¹⁷ cm⁻³-1 × 10²⁰ cm⁻³, such as n-doping = 5 × 10¹⁸ cm⁻³.

A thickness of the at least one conductive layer 106 may be in the range of 10-500 nm, such as in the range of 200-300 nm.

The device 100 may comprise an Al_{c}Ga_{1-c}N strain relaxation layer 104 interposed between the substrate 102 and the at least one conductive layer 106. The composition of the Al_{c}Ga_{1-c}N strain relaxation layer 104 may vary where c is from and including 0 to and including 1. For example, the strain relaxation layer 104 may be an Al_{0.6}Ga_{0.4}N layer.

The strain relaxation layer 104 may mitigate any differences in lattice constant between the substrate 102 and the conductive layer 106, such that the amount of crystal defects may be reduced.

A first electrical contact 108 is arranged on the conductive layer 106. The first electrical contact 108 may be configured to form electrical contact with the conductive layer 106. However, this does not imply that the first electrical contact 108 necessarily needs to be in direct physical contact with the conductive layer 106. On the contrary, one or more layers may be interposed between the first electrical contact 108 and the conductive layer 106 such that electrical contact is provided via an intermediate layer.

The first electrical contact 108 may be formed of a metal with high electrical conductivity, such as copper, aluminum or silver. Alternatively, the first electrical contact 108 may be formed of a semiconductor material, such as polycrystalline or amorphous silicon. The semiconductor material may be an n-type semiconductor material.

A far-UVC quantum well 120 is arranged on the conductive layer 106. The quantum well 120 comprises an aluminum-gallium-nitride based stack. This implies that the quantum well 120 comprises a plurality of layers arranged on top of each other, wherein the layers comprise aluminum-gallium-nitride. The stack of the quantum well 120 may comprise a plurality of Al_{f}Ga_{1-f}N layers defining at least one first Al_{f1}Ga_{1-f1}N layer 122 and at least one second Al_{f2}Ga_{1-f2}N layer 124, where f1 is different from f2. The plurality of Al_{f}Ga_{1-f}N layers may form a multiple quantum well.

The composition of the at least one first Al_{f1}Ga_{1-f1}N layer 122 and the at least one second Al_{f2}Ga_{1-f2}N layer 124 may vary where f1 and f2 may be from and including 0 to and including 1.

The layers of the plurality of Al_{f}Ga_{1-f}N layers may be arranged on top of each other. The layers of the plurality of Al_{f}Ga_{1-f}N layers may be arranged such that the at least one first Al_{f1}Ga_{1-f1}N layer 122 and the at least one second Al_{f2}Ga_{1-f2}N layer 124 may be alternatingly arranged on top of each other in the stack.

The quantum well 120 may, e.g., comprise alternating layers of Al_{0.9}Ga_{0.1}N and Al_{0.8}Ga_{0.2}N. The quantum well 120 may comprise five layers of Al_{0.9}Ga_{0.1}N and five layers of Al_{0.8}Ga_{0.2}N.

The at least one first Al_{f1}Ga_{1-f1}N layer 122 may have such a composition that the Al content is higher than that of an adjacent layer. This implies that the bandgap of each of the at least one first Al_{f1}Ga_{1-f1}N layer 122 may be higher than that of an adjacent second Al_{f2}Ga_{1-f2}N layer 124. Hence, each of the at least one first Al_{f1}Ga_{1-f1}N layer 122 may define a barrier region. This implies that each of the at least one second Al_{f2}Ga_{1-f2}N layer 124 may define a well region.

For instance, each of the at least one first Al_{f1}Ga_{1-f1}N layer 122 may be formed of an Al_{0.9}Ga_{0.1}N layer. It should be understood that each of the at least one first Al_{f1}Ga_{1-f1}N layer 122 may differ from each other in composition such that f1 may not be the same value for all layers.

For instance, each of the at least one second Al_{f2}Ga_{1-f2}N layer 124 may be formed of an Al_{0.8}Ga_{0.2}N layer. It should be understood that each of the at least one second Al_{f2}Ga_{1-f2}N layer 124 may differ from each other in composition such that f2 may not be the same value for all layers.

The plurality of Al_{f}Ga_{1-f}N layers forming the quantum well 120 may comprise any number of layers.

The quantum well 120 may be configured such that emitted light may propagate in a direction being perpendicular to a stacking direction of the layers of the quantum well 120. This may provide a possibility to form the substrate 102 of silicon carbide (SiC). SiC is conductive but not sufficiently transparent to far-UVC. By the substrate 102 being formed of conductive SiC it is possible to fabricate a vertical current flow device, configured to emit light in a direction being perpendicular to a stacking direction of the layers of the quantum well 120, having a top p-type contact and a bottom n-type contact. Hence, a far-UVC device 100 having a small footprint may be provided.

Alternatively, the quantum well 120 may be configured such that emitted light may propagate in a direction being parallel with a stacking direction of the layers of the quantum well 120.

The far-UVC quantum well 120 and the first electrical contact 108 may be arranged side-by-side on the conductive layer 106. Thus, the far-UVC quantum well 120 and the first electrical contact 108 may be associated with different areas of the conductive layer 106.

The at least one first Al_{f1}Ga_{1-f1}N layer 122 and the at least one second Al_{f2}Ga_{1-f2}N layer 124 of the quantum well 120 may have a thickness such that quantum confinement occurs. The wavelength of the emitted light of an active region of the quantum well 120 is not only determined by the bandgap of the materials from which the active region is constructed, but also the thickness of each of the at least one first Al_{f1}Ga_{1-f1}N layer 122 and the at least one second Al_{f2}Ga_{1-f2}N layer 124 of the active region of the quantum well 120. A thickness of the active region may be defined as the sum of the thickness of each of the at least one first Al_{f1}Ga_{1-f1}N layer 122 and the at least one second Al_{f2}Ga_{1-f2}N layer 124 of the quantum well 120 along a stacking direction thereof. The thickness of the at least one first Al_{f1}Ga_{1-f1}N layer 122 and the at least one second Al_{f2}Ga_{1-f2}N layer 124 may be designed depending on which wavelength of the emitted light is desired. Hence, it should be understood that each of the at least one first Al_{f1}Ga_{1-f1}N layer 122 and each of the at least one second Al_{f2}Ga_{1-f2}N layer 124 is not limited to a specific thickness.

For instance, each of the at least one first Al_{f1}Ga_{1-f1}N layer 122 may be formed of Al_{0.9}Ga_{0.1}N being 15 nm thick. This implies a quantum confinement being equivalent to approximately 10 kT at room temperature. It should be understood that each of the at least one first Al_{f1}Ga_{1-f1}N layer 122 may differ from each other in thickness.

For instance, each of the at least one second Al_{f2}Ga_{1-f2}N layer 124 may be formed of Al_{0.8}Ga_{0.2}N layer being 5 nm thick. This is equivalent to a bandgap having a bandgap energy being equivalent to a wavelength of approximately 200-230 nm. It should be understood that each of the at least one second Al_{f2}Ga_{1-f2}N layer 124 may differ from each other in thickness.

An electron blocking layer (EBL) 126 is arranged on the quantum well 120. The EBL 126 may be configured to block electrons from entering the p-type AlₐGa₁₋ₐN layer 132. This implies that the EBL 126 facilitates in preventing that recombination, and thus charge neutralization, occurs in the p-type AlₐGa₁₋ₐN layer 132. Hence, parasitic effects may be reduced.

The EBL 126 may be structured in a number of different ways. The EBL 126 may be a trapezoidal electron blocking layer, a multilayer electron blocking layer, a graded electron blocking layer or a wedge-shaped electron blocking layer having a linearly graded composition.

The EBL 126 is aluminum-gallium-nitride based. The EBL 126 may be formed of an Al_{g}Ga_{1-g}N layer. The composition of the Al_{g}Ga_{1-g}N electron blocking layer may be such that g is in the range of 0 - 1, such as g = 0.95 - 1.

A thickness of the EBL 126 may be in the range of 10 - 200 nm, such as in the range of 20 - 50 nm.

The far-UVC device 100 further comprises a p-type ohmic contact 130. The p-type ohmic contact 130 is arranged on the EBL 126 and being in electrical contact with the quantum well 120. However, this does not imply that the p-type ohmic contact 130 needs to be directly on and in direct contact with the EBL 126. On the contrary, one or more layers may be interposed between the p-type ohmic contact 130 and the EBL 126. Further, one or more layers may be interposed between the EBL 126 and the quantum well 120. The p-type ohmic contact 130 is configured to form a tunneling-based ohmic contact. This implies that p-type ohmic contact 130 may form a tunnel junction.

The p-type ohmic contact 130 is configured to inject carriers into the quantum well 120 via the tunnel junction. The p-type ohmic contact 130 may be configured to inject holes into the quantum well 120 via the tunnel junction. The tunnel junction is configured to be arranged such that an effective carrier injection into the active region of the quantum well 120 is achieved. Injected carriers from the p-type ohmic contact 130 may then recombine with injected carriers from the first electrical contact 108 in the active region in the quantum well 120 and thereby light may be emitted.

The p-type tunneling-based ohmic contact 130 may be configured to operate in reverse bias. Thus, this may allow the device 100 to emit light.

Alternatively, the device 100 may be configured to detect far-UVC light. The term *"far-UVC"* should be interpreted as electromagnetic radiation corresponding to a wavelength range of approximately 200-230 nm.

The p-type ohmic contact 130 may comprise a p-type AlₐGa₁₋ₐN layer 132 arranged on the EBL and being in electrical contact with the quantum well 120. The p-type ohmic contact 130 may further comprise an n-type (Al_{b}Ga_{1-b})₂O₃ layer 134 and a second electrical contact 136.

The n-type (Al_{b}Ga_{1-b})₂O₃ layer 134 is interposed between the p-type AlₐGa₁₋ₐN layer 132 and the second electrical contact 136. However, this does not imply that the n-type (Al_{b}Ga_{1-b})₂O₃ layer 134 needs to be in direct contact with the p-type AlₐGa₁₋ₐN layer 132. On the contrary, one or more layers may be interposed between the n-type (Al_{b}Ga_{1-b})₂O₃ layer 134 and the p-type AlₐGa₁₋ₐN layer 132. For instance, a modification layer may be formed on the p-type AlₐGa₁₋ₐN layer, such that the modification layer is interposed between the p-type AlₐGa₁₋ₐN layer and the n-type (Al_{b}Ga_{1-b})₂O₃ layer. The modification layer may, e.g., facilitate the formation of the (Al_{b}Ga_{1-b})₂O₃ layer. The modification layer may also mitigate any differences in lattice constant between the p-type AlₐGa₁₋ₐN layer and the n-type (Al_{b}Ga_{1-b})₂O₃ layer. The modification layer may further reduce interface traps.

The p-type AlₐGa₁₋ₐN layer 132 may be compositionally graded such that, at an interface with the EBL 126, a is different than at an interface with the n-type (Al_{b}Ga_{1-b})₂O₃ layer. A graded composition of the p-type AlₐGa₁₋ₐN layer 132 allows for a respective lattice mismatch between the p-type AlₐGa₁₋ₐN layer 132 and the EBL 126 and a respective lattice mismatch between the p-type AlₐGa₁₋ₐN layer 132 and the n-type (Al_{b}Ga_{1-b})₂O₃ layer 134 to be reduced. The composition of the p-type AlₐGa₁₋ₐN layer 132 may be such that a is in the range of 0 - 1 at the interface with the EBL 126, such as a = 0.9. Further, the composition of the p-type AlₐGa₁₋ₐN layer 132 may be such that a is in the range of 0 - 1 at the interface with the n-type (Al_{b}Ga_{1-b})₂O₃ layer, such as a = 0.

The p-type AlₐGa₁₋ₐN layer 132 may be linearly graded such that a three-dimensional hole gas (3DHG) therein is formed. This may contribute to a higher hole density.

The p-type AlₐGa₁₋ₐN layer 132 may be doped. The doping of the p-type AlₐGa₁₋ₐN layer 132 may be in the range of p-doping = 1 × 10¹⁶ cm⁻³-5 × 10¹⁸ cm⁻³, such as p-doping = 5 × 10¹⁷ cm⁻³.

A thickness of the p-type AlₐGa₁₋ₐN layer 132 may be in the range of 10-200 nm, such as in the range of 20-50 nm. The n-type (Al_{b}Ga_{1-b})₂O₃ layer 134 may be configured to be UV-transparent. This implies that the bandgap of the n-type (Al_{b}Ga_{1-b})₂O₃ layer 134 may be relatively high so as to reduce light absorption. The n-type (Al_{b}Ga_{1-b})₂O₃ layer 134 may be configured such that the bandgap thereof is in the range of 4.0 to 8.0 eV, such as 4.25 to 7.5 eV, or 4.5 to 7.0 eV. The composition of the n-type (Al_{b}Ga_{1-b})₂O₃ layer 134 may be such that b is in the range of 0 - 1, such as b = 0.

The n-type (Al_{b}Ga_{1-b})₂O₃ layer 134 may be doped. The doping of the n-type (Al_{b}Ga_{1-b})₂O₃ layer 134 may be in the range of n-doping = 1 × 10¹⁶ cm⁻³ - 5 × 10¹⁹ cm⁻³, such as n-doping = 5 × 10¹⁸ cm⁻³.

A thickness of the n-type (Al_{b}Ga_{1-b})₂O₃ layer 134 may be in the range of 10-200 nm, such as in the range of 20-50 nm.

The second electrical contact 136 is arranged on the n-type (Al_{b}Ga_{1-b})₂O₃ layer 134. The second electrical contact 136 may be configured to form electrical contact with the n-type (Al_{b}Ga_{1-b})₂O₃ layer 134. However, this does not imply that the second electrical contact 136 needs to be in direct contact with the n-type (Al_{b}Ga_{1-b})₂O₃ layer 134. On the contrary, one or more layers may be interposed between the second electrical contact 136 and the n-type (Al_{b}Ga_{1-b})₂O₃ layer 134 such that electrical contact is provided via an intermediate layer.

The second electrical contact 136 may be formed of a metal with high electrical conductivity, such as copper, aluminum or silver. Alternatively, the second electrical contact 136 may be formed of a semiconductor material, such as polycrystalline or amorphous silicon. The semiconductor material may be an n-type semiconductor material.

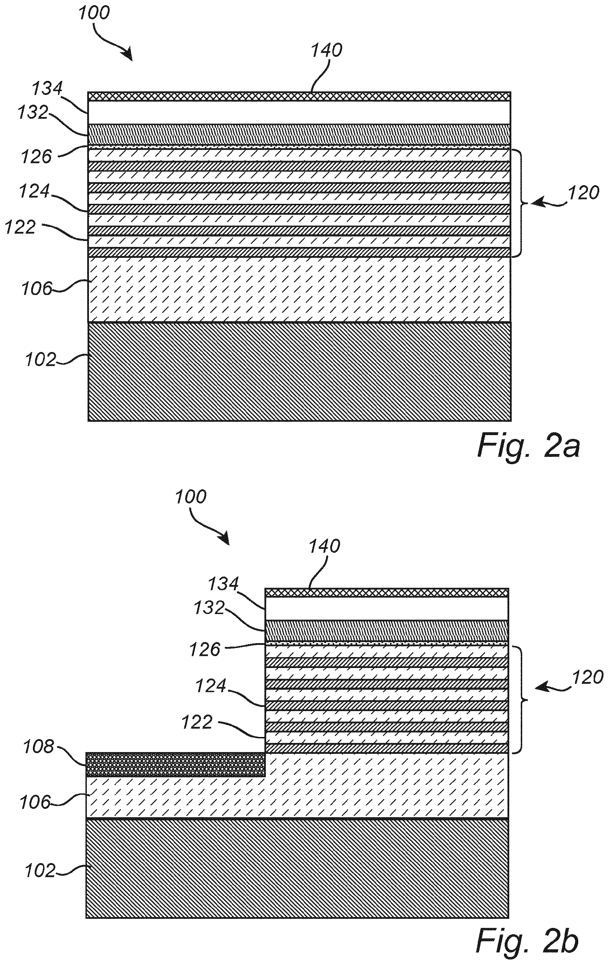

Referring now to Figs 2a-d, a method for fabricating a far-UVC device 100 with special focus on the formation of the first electrical contact 108 and the second electrical contact 136 according to an embodiment will be described.

Referring now to Fig. 2a, the far-UVC device 100 may be fabricated on a substrate 102. The substrate 102 may be configured to be transparent so as to allow light to propagate through the substrate 102.

The method may comprise planarizing a top surface of the substrate 102. A smooth top surface of the substrate 102 may thus be formed. Thus, the substrate 102 may provide a flat top surface, which facilitates forming of layers above the substrate 102. A smooth top surface of the substrate 102 may also facilitate reducing light absorption at an interface between the substrate 102 and any subsequently formed layer on the substrate 102.

The method may further comprise planarizing a bottom surface of the substrate 102. A smooth bottom surface of the substrate 102 may thus be formed. A smooth bottom surface of the substrate 102 may facilitate reducing light absorption.

The planarizing of the substrate 102 may for instance be achieved by chemical mechanical polishing (CMP).

The method further comprises depositing at least one conductive layer 106 on the substrate 102. The at least one conductive layer 106 may form a layer arranged on a surface of the substrate 102 and parallel therewith. The conductive layer 106 is configured to be arranged in contact with the substrate 102. It should be understood that the at least one conductive layer 106 may be formed on a strain relaxation layer 104 arranged on the substrate 102.

The at least one conductive layer 106 according to any of the embodiments discussed above may be formed. Thus, the at least one conductive layer 106 may be any type of conductive layer. The conductive layer 106 may be an n-type AlₑGa₁₋ₑN layer. The composition of the n-type AlₑGa₁₋ₑN layer may vary where e is from and including 0 to and including 1. For example, the conductive layer 106 may be an n-type Al_{0.9}Ga_{0.1}N layer.

The at least one conductive layer 106 may be deposited on the substrate 102 by conventional semiconductor fabrication technology, such as metalorganic chemical vapour deposition (MOCVD).

The at least one conductive layer 106 may be formed as a continuous layer extending over an entire area in which a quantum well 120 is to be formed.

The deposition of material may form at least one conductive layer 106 which has a homogeneous thickness.

All following steps of producing layers may be provided by conventional semiconductor fabrication technology, such as steps involving thin-film deposition.

The method may further comprise planarizing the at least one conductive layer 106. A smooth top surface of the at least one conductive layer 106 may thus be formed after deposition of the at least one conductive layer 106 on the substrate 102 has been performed. Thus, the at least one conductive layer 106 may provide a flat top surface, which facilitates forming of layers above the at least one conductive layer 106.

The planarizing of the at least one conductive layer 106 may for instance be achieved by CMP.

The method further comprises forming a quantum well 120 on the at least one conductive layer 106. The method may comprise forming a multiple quantum well. The quantum well 120 may comprise an aluminum-gallium-nitride based stack and being arranged on a surface of the at least one conductive layer 106 and parallel therewith. The quantum well 120 is configured to be arranged in contact with the at least one conductive layer 106.

The quantum well 120 according to any of the embodiments discussed above may be formed. Thus, the quantum well 120 may comprise a plurality of Al_{f}Ga_{1-f}N layers defining at least one first Al_{f1}Ga_{1-f1}N layer 122 and at least one second Al_{f2}Ga_{1-f2}N layer 124.

The forming of the quantum well 120 comprises alternatingly depositing layers of aluminum-gallium-nitride on a portion of the at least one conductive layer 106 so as to form an aluminum-gallium-nitride based stack. This implies that forming the quantum well 120 may comprise alternatingly depositing at least one first Al_{f1}Ga_{1-f1}N layer 122 and at least one second Al_{f2}Ga_{1-f2}N layer 124 on top of each other so as to form an aluminum-gallium-nitride based stack.

Each of the layers of the quantum well 120 may be formed by conventional semiconductor fabrication technology.

Each of the layers of the quantum well 120 may be formed by thin-film deposition.

The at least one first Al_{f1}Ga_{1-f1}N layer 122 may have such a composition that the Al content is higher than that of an adjacent layer. This implies that the bandgap of each of the at least one first Al_{f1}Ga_{1-f1}N layer 122 may be higher than that of an adjacent second Al_{f2}Ga_{1-f2}N layer 124. Hence, each of the at least one first Al_{f1}Ga_{1-f1}N layer 122 may define a barrier region. This implies that each of the at least one second Al_{f2}Ga_{1-f2}N layer 124 may define a well region. Thus, the forming of each of the at least one barrier region and the at least one wall region may comprise varying the Al content of the at least one first Al_{f1}Ga_{1-f1}N layer 122 compared to the at least one second Al_{f2}Ga_{1-f2}N layer 124 when forming each of the layers of the at least one first Al_{f1}Ga_{1-f1}N layer 122 and the at least one second Al_{f2}Ga_{1-f2}N layer 124. The forming of the at least one first Al_{f1}Ga_{1-f1}N layer 122 may comprise forming the at least one first Al_{f1}Ga_{1-f1}N layer 122 with a higher Al content than that of an adjacent second Al_{f2}Ga_{1-f2}N layer 124.

As further illustrated in Fig. 2a, the method further comprises forming an aluminum-gallium-nitride based electron block layer (EBL) 126 on the quantum well 120. The EBL 126 may form a layer arranged on the quantum well 120. The EBL 126 may be deposited on the quantum well 120 so as to form an interlayer between the quantum well 120 and a p-type ohmic contact 130.

The EBL 126 according to the embodiments as discussed above may be formed. The EBL 126 may be formed of a Al_{g}Ga_{1-g}N layer. The composition of the Al_{g}Ga_{1-g}N EBL 126 may vary, with g being in a range of 0 - 1, such as g = 0.95 - 1.

For instance, depositing the Al_{g}Ga_{1-g}N EBL 126 on the quantum well 120 may comprise gradingly depositing aluminum such that at an interface with the quantum well 120, g is different from at an interface with the p-type ohmic contact 130.

The EBL 126 may be formed by conventional semiconductor fabrication technology.

The EBL 126 may be formed by thin-film deposition.

The method further comprises forming a p-type ohmic contact 130 on the EBL 126. The p-type ohmic contact 130 according to the embodiments as discussed above may be formed. The p-type ohmic contact 130 may comprise a p-type AlₐGa₁₋ₐN layer 132 arranged directly on the EBL 126 and being in electrical contact with the quantum well 120. The p-type ohmic contact 130 may further comprise an n-type (Al_{b}Ga_{1-b})₂O₃ layer 134 and a second electrical contact 136. The n-type (Al_{b}Ga_{1-b})₂O₃ layer 134 is interposed between the p-type AlₐGa₁₋ₐN layer 132 and a second electrical contact 136.

Forming the p-type ohmic contact 130 comprises depositing a p-type AlₐGa₁₋ₐN layer 132 on the EBL 126. The composition of the p-type AlₐGa₁₋ₐN layer 132 may vary, with a being in a range of 0 - 1. The composition of the p-type AlₐGa₁₋ₐN layer 132 may be graded. Depositing the p-type AlₐGa₁₋ₐN layer 132 on the EBL 126 may comprise gradingly depositing aluminum such that the p-type AlₐGa₁₋ₐN layer 132 is compositionally graded such that at an interface with the EBL 126, a is different than at an interface with the n-type (Al_{b}Ga_{1-b})₂O₃ layer 134. This implies that the bandgap and/or the lattice constant of the p-type AlₐGa₁₋ₐN layer 132 at an interface with the EBL 126 may be different than at an interface with the n-type (Al_{b}Ga_{1-b})₂O₃ layer 134 or any other layer interposed between the p-type AlₐGa₁₋ₐN layer 132 and the n-type (Al_{b}Ga_{1-b})₂O₃ layer 134.

The p-type AlₐGa₁₋ₐN layer 132 may be formed by conventional semiconductor fabrication technology.

The p-type AlₐGa₁₋ₐN layer 132 may be formed by thin-film deposition.

Forming the p-type ohmic contact 130 further comprises depositing n-type (Al_{b}Ga_{1-b})₂O₃ layer 134 on the p-type AlₐGa₁₋ₐN layer 132. However, this does not imply that the n-type (Al_{b}Ga_{1-b})₂O₃ layer 134 needs to be in direct contact with the p-type AlₐGa₁₋ₐN layer 132. On the contrary, one or more layers may be interposed between the p-type AlₐGa₁₋ₐN layer 132 and the n-type (Al_{b}Ga_{1-b})₂O₃ layer 134 such that electrical contact is provided via an intermediate layer. For instance, forming the p-type ohmic contact 130 may comprise depositing a modification layer on the p-type AlₐGa₁₋ₐN layer 132, such that the modification layer is interposed between the p-type AlₐGa₁₋ₐN layer 132 and the n-type (Al_{b}Ga_{1-b})₂O₃ layer 134.

The forming of the n-type (Al_{b}Ga_{1-b})₂O₃ layer 134 may comprise depositing a catalyst layer on the p-type AlₐGa₁₋ₐN layer 132 or any other layer being arranged on the p-type AlₐGa₁₋ₐN layer 132 and growing the n-type (Al_{b}Ga_{1-b})₂O₃ layer 134 in contact with the catalyst layer.

The catalyst layer may comprise any suitable catalyst. For example, the catalyst layer may comprise antimonide. The catalyst layer may, e.g., facilitate the formation of the (Al_{b}Ga_{1-b})₂O₃ layer 134.

The composition of the n-type (Al_{b}Ga_{1-b})₂O₃ layer 134 may vary, with b being in a range of 0 - 1. The composition of the n-type (Al_{b}Ga_{1-b})₂O₃ layer 134 may be graded.

The n-type (Al_{b}Ga_{1-b})₂O₃ layer 134 may be formed by conventional semiconductor fabrication technology.

The n-type (Al_{b}Ga_{1-b})₂O₃ 134 may be formed in a separate process than what is used for forming the p-type AlₐGa₁₋ₐN layer. Suitable deposition methods for forming the (Al_{b}Ga_{1-b})₂O₃ layer may be physical vapor deposition such as magnetron sputtering, pulsed laser deposition, or e-beam evaporation. This allows for the possibility to deposit the second electrical contact using the same tool for forming (Al_{b}Ga_{1-b})₂O₃ layer. This improves control of an interface between the second electrical contact and the (Al_{b}Ga_{1-b})₂O₃ layer or any other intermediate layer being interposed between the second electrical contact and the (Al_{b}Ga_{1-b})₂O₃ layer. Thus, the amount of interface traps may be reduced.

The n-type (Al_{b}Ga_{1-b})₂O₃ layer 134 may be formed by thin-film deposition.

Referring now to Fig. 2b, the method further comprises covering the stack of layers with a first mask 140 and partially etching the first mask 140 so as to expose a portion of the at least one conductive layer 106. The first mask 140 may be deposited on the n-type (Al_{b}Ga_{1-b})₂O₃ layer 134 so as to being arranged on at least a portion of a surface of the n-type (Al_{b}Ga_{1-b})₂O₃ layer 134.

The method further comprises depositing a first electrical contact 108 on the exposed portion of the at least one conductive layer 106. Thus, the first electrical contact 108 may provide electrical contact with the at least one conductive layer 106. The first electrical contact 108 may form a layer arranged on the exposed portion of the at least one conductive layer 106 and parallel therewith.

The deposition of material may form a first electrical contact 108 which has a homogeneous thickness.

Forming of the first electrical contact 108 may involve patterning steps, such as using lithography and etching, which may be provided by equipment readily available at the semiconductor fabrication plant.

The first electrical contact 108 may be formed by conventional semiconductor fabrication technology.

The first electrical contact 108 may be formed by thin-film deposition. This may provide a flexibility in choice of material.

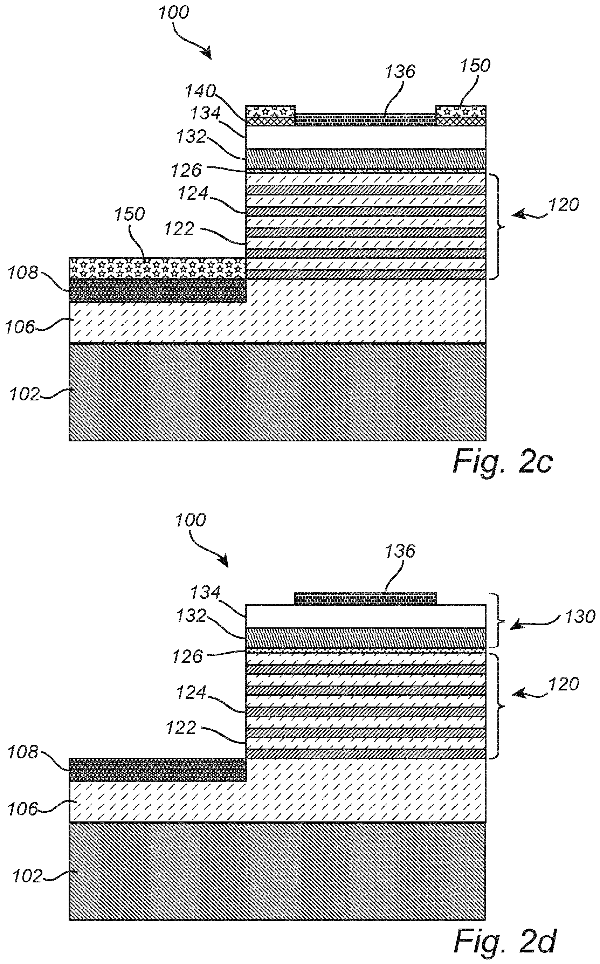

Referring now to Fig. 2c, forming the p-type ohmic contact 130 further comprises covering the first mask 140, the first electrical contact 108 and the n-type (Al_{b}Ga_{1-b})₂O₃ layer 134 with a second mask 150 and partially etching the second mask 150 and the first mask 140 so as to expose a portion of the n-type (Al_{b}Ga_{1-b})₂O₃ layer 134. The second mask 150 may be deposited on the first mask 140, the first electrical contact 108 and the n-type (Al_{b}Ga_{1-b})₂O₃ layer 134 so as to being arranged on at least a portion of a surface of the first mask 140, the first electrical contact 108 and the n-type (Al_{b}Ga_{1-b})₂O₃ layer 134.

Forming the p-type ohmic contact 130 further comprises depositing a second electrical contact 136 on the exposed portion of the n-type (Al_{b}Ga_{1-b})₂O₃ layer 134. Thus, the second electrical contact 136 may provide electrical contact with the n-type (Al_{b}Ga_{1-b})₂O₃ layer 134. The second electrical contact 136 may form a layer arranged on the exposed portion of the n-type (Al_{b}Ga_{1-b})₂O₃ layer 134 and parallel therewith.

The deposition of material may form a second electrical contact 136 which has a homogeneous thickness.

Forming of the second electrical contact 136 may involve patterning steps, such as using lithography and etching, which may be provided by equipment readily available at the semiconductor fabrication plant.

The second electrical contact 136 may be formed by conventional semiconductor fabrication technology.

Suitable deposition methods for forming the second electrical contact 136 may be physical vapor deposition such as magnetron sputtering, pulsed laser deposition, or e-beam evaporation. The tools used to deposit the second electrical contact 136 may be the same ones as those being used to form the n-type (Al_{b}Ga_{1-b})₂O₃ layer 134.

The second electrical contact 136 may be formed by thin-film deposition. This may provide a flexibility in choice of material.

Referring now to Fig. 2d, the method may further comprise removing the first mask 140 and the second mask 150 by conventional semiconductor processing. Fig. 2d illustrates a fabricated far-UVC device 100 according to an embodiment as discussed above.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A far-UVC device (100) for emitting and/or detecting far-UVC light comprising:
a substrate (102);
at least one conductive layer (106) arranged on the substrate (102);
a first electrical contact (108) arranged on the at least one conductive layer (106);
a far-UVC quantum well (120) comprising an aluminum-gallium-nitride based stack, wherein the far-UVC quantum well (120) is arranged on the conductive layer (106);
an aluminum-gallium-nitride based electron blocking layer (EBL) (126) arranged on the quantum well (120);
a p-type AlₐGa₁₋ₐN layer (132) arranged on the EBL (126) and being in electrical contact with the quantum well (120), wherein the device (100) further comprises an n-type (Al_{b}Ga_{1-b})₂O₃ layer (134) interposed between a second electrical contact (136) and the p-type AlₐGa₁₋ₐN layer (132), wherein b is from and including 0 to and including 1 and a is from and including 0 to and including 1.

2. The far-UVC device according to claim 1, wherein the p-type AlₐGa₁₋ₐN layer (132) is compositionally graded such that, at an interface with the EBL (126), a is different than at an interface with the n-type (Al_{b}Ga_{1-b})₂O₃ layer (134).

3. The far-UVC device according to claim 2, wherein a is 0.9 at the interface with the EBL (126) and a is 0 at the interface with the (Al_{b}Ga_{1-b})₂O₃ layer (134).

4. The far-UVC device according to any preceding claim, wherein the second electrical contact (136) is a metal.

5. The far-UVC device according to any one of claims 1 to 3, wherein the second electrical contact (136) is an n-type semiconductor material.

6. The far-UVC device according to any preceding claim, wherein the n-type (Al_{b}Ga_{1-b})₂O₃ layer (134) has a bandgap in the range of 4.0 to 8.0 eV, or 4.25 to 7.5 eV, or 4.5 to 7.0 eV.

7. The far-UVC device according to any preceding claim, further comprising an Al_{c}Ga_{1-c}N strain relaxation layer (104) interposed between the substrate (102) and the at least one conductive layer (106), wherein c is from and including 0 to and including 1.

8. The far-UVC device according to any preceding claim, further comprising a modification layer interposed between the p-type AlₐGa₁₋ₐN layer (132) and the n-type (Al_{b}Ga_{1-b})₂O₃ layer (134).

9. Method for fabricating a far-UVC device for emitting and/or detecting far-UVC light is provided according to claim 1, comprising:
depositing at least one conductive layer (106) on a substrate (102);
forming a quantum well (120) for light emittance or detection comprising alternatingly depositing layers of aluminum-gallium-nitride on the at least one conductive layer (106) so as to form an aluminum-gallium-nitride based stack;
forming an aluminum-gallium-nitride based electron blocking layer (EBL) (126) on the quantum well (120);
depositing a p-type AlₐGa₁₋ₐN layer (132) on the EBL (126), wherein a is from and including 0 to and including 1;
forming an n-type (Al_{b}Ga_{1-b})₂O₃ layer (134) on the p-type AlₐGa₁₋ₐN layer (132), wherein b is from and including 0 to and including 1;
covering the stack of layers with a first mask (140);
partially etching the first mask (140) so as to expose a portion of the at least one conductive layer (106);
depositing a first electrical contact (108) on the at least one conductive layer (106);
covering the first mask (140), the first electrical contact (108), and the (Al_{b}Ga_{1-b})₂O₃ layer (134) with a second mask (150);
partially etching the second mask (150) and the first mask (140), and
depositing a second electrical contact (136) on the n-type (Al_{b}Ga_{1-b})₂O₃ layer (134);

10. The method according to claim 10, wherein depositing a p-type AlₐGa₁₋ₐN layer (132) comprises gradingly depositing aluminum such that the p-type AlₐGa₁₋ₐN layer (132) is compositionally graded such that, at an interface with the EBL (126), a is different than at an interface with the n-type (Al_{b}Ga_{1-b})₂O₃ layer (134).

11. The method according to any preceding claim, further comprising depositing a modification layer on the p-type AlₐGa₁₋ₐN layer (132), such that the modification layer is interposed between the p-type AlₐGa₁₋ₐN layer (132) and the n-type (Al_{b}Ga_{1-b})₂O₃ layer (134).

12. The method according to any preceding claim, wherein forming an n-type (Al_{b}Ga_{1-b})₂O₃ layer (134) comprises depositing a catalyst layer on the p-type AlₐGa₁₋ₐN layer and growing the n-type (Al_{b}Ga_{1-b})₂O₃ layer (134) in contact with the catalyst layer.
